# EUROPEAN PATENT APPLICATION

(11) **EP 1 219 397 A1**
(43) Date of publication of application: **03.07.2002**
(21) Application number: 00128545.1
(22) Date of filing: 27.12.2000
(51) Int. Cl.: B28D 5/00, H01L 21/00

(54) **Method and apparatus for loading, unloading and transferring semiconductor bars**

(71) Applicant: Optical Technologies Italia S.p.A., 20126 Milano (IT)
(72) Inventor: Reichenbach, Davide, 20124 Milano (IT); Lamendola, Ritalba, 20100 Milano (IT); Di Egidio, Marco, 20038 Seregno (MI) (IT); Redaelli, Luigi, 20049 Concorezzo (MI) (IT)
(74) Representative: Giannesi, Pier Giovanni

(57) **Abstract**

Method for moving a plurality of semiconductor bars in the stages of positioning them on and removing them from equipment for producing semiconductor devices, comprising the stages of:
- simultaneously picking up the said semiconductor bars contained in a process support of a first machine which carries out a first processing operation on the said bars;
- simultaneously positioning the said bars adjacent to each other;
- inserting the said bars, adjacent to each other, into a support for a second stage of processing.

## Description

The present invention relates to the movement of batches of semiconductor bars, in the stages of positioning them on, and removing them from, equipment for producing semiconductor optical devices such as semiconductor lasers, semiconductor optical amplifiers and passive optical devices.

Such fabrication equipment generally comprises a plurality of machines in which different stages of the process of fabrication of semiconductor devices are carried out.

US Patent 5,305,340 describes a semiconductor laser device which has a protective configuration for a guide element. This protective configuration comprises layers of metallic material applied on each side of the guide element. The laser structure is mounted in an inverted position on a support surface and the layer of metallic protection can be made from gold.

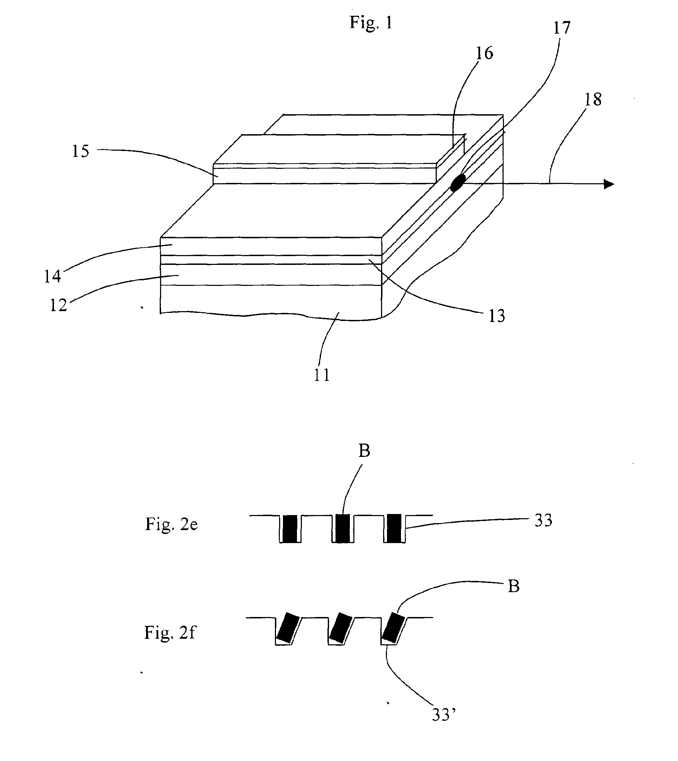

Figure 1 shows a laser 1 of the type described in the aforesaid patent which comprises a substrate 11 on which is superimposed a first cladding surface 12. An active layer 13 is placed on the said first cladding surface, and a second cladding surface 14 is placed on top. On the central portion of the said cladding surface there is placed a guide element 15, elongate in the longitudinal direction, on which a metallized electrical contact layer 16 is superimposed. A further electrical contact is placed on the lower surface of the substrate 11.

The active region of the said active layer 13 is delimited by the dimension of the elongate guide 15 and is represented in the figure as an ellipse 17 centred on the edge of the active layer 13.

When an appropriate voltage is applied between the two described contacts, an electric current passes vertically through the laser and activates the ions of the active layer 13. The guide element 15 forces the light to travel in the longitudinal direction, and the laser emits a beam of light in the direction indicated by the arrow 18 in Figure 1.

Typical materials used to make the said laser are N-GaAs for the substrate 11, N-AlGaAs for the first cladding layer 12, P-AlGaAs for the second cladding layer 14, AlGaAs for the active layer 13 and P-GaAs for the metallized electrical contact layer 16.

An example of a process for making optical devices on substrates of semiconductor material is a semiconductor laser production process; this process essentially comprises the following stages:
a) forming a plurality of superimposed layers of the aforesaid materials on a substrate of semiconductor material (wafer), of circular shape for example, in order to form a plurality of optical devices which are essentially identical to each other;
b) dividing the substrate into a plurality of bars, each containing a predetermined number of the said devices adjacent to each other (cleaving wafer); if the said devices are semiconductor lasers, facets are created on the cut surfaces, in other words on the opposite sides of each bar, these facets being covered with mirrors which confine the light beam within each laser;
c) passivating these facets on each bar in order to protect the surfaces of the facets from impurities;
d) stacking the bars together in a support for subsequent processing, in such a way that the facet faces, on which the said subsequent processing will be carried out, all lie on the same plane;
e) forming a coating on these facets in such a way as to impart the characteristics of reflectivity suitable for the correct operation of each laser in the bar;
f) cutting each bar in such a way that each laser device is separated.

Stage a) requires an organized process flow which requires, initially, the production of a multiple semiconductor layer by epitaxial growth, in other words a growth of the deposited material in the form of crystals with specified characteristics. This deposition is carried out, for example, by the MBE (molecular beam epitaxial) or MOCVD (metal-organic chemical vapour deposition) process. The guide elements 15 are then formed on the said layers by chemical etching according to the geometries determined by a mask. With the mask still in position, a dielectric film is deposited over the whole surface of the wafer by a PECVD (plasma-enhanced chemical vapour deposition) process. Subsequent removal of the mask leaves the surface of the guide elements exposed while all the rest is electrically insulated. An evaporator is used to deposit the metallic films in such a way that the surfaces of the guide elements are electrically contacted. At this point, the contact metallization on the sides of the guide elements is increased by application of direct current, using a second mask, in such a way that these elements are permanently protected mechanically for the subsequent stages of the process. The underside of the wafer is machined to make the wafer thinner, and an evaporation system is used to deposit the metallic films which form the other electrical contact of the device.

Stages b) and c) are carried out in a machine in which the processes are carried out in a UHV (ultrahigh vacuum) environment. In a first stage, the wafer is cut into bars; thus facets are formed on the cut surfaces. A magnetic transfer device picks up each bar, and a layer of material is deposited on both of the cut surfaces on which the said facets are formed, to create a protective barrier against the impurities which are capable of modifying the characteristics of the semiconductor material (the passivation process). The said magnetic support then inserts each bar into a bar support. The bar support has a plurality of notches into which the laser bars are inserted parallel to each other.

US Patent 5,154,333 describes a device for cutting laser bars as described above; the device, making use of an incision formed previously on the cutting line, applies a force which propagates the cleavage until the bars are physically separated from each other. US Patent 5,391,036 describes a magnetic transfer device as described above, which picks up each bar from the cutting position and carries it to the positions where subsequent processing takes place. US Patent 5,063,173 describes a method for carrying out the passivation of the mirrors as described above.

The stage e) is carried out, for example, by a PECVD process, in order to provide mirror surfaces with a specified and controlled reflectivity. This operation is carried out on the sides of the bars on which the facets are located. Since the mirrors are formed on opposite sides of the rectangular bar, the deposition takes place first on one side of all the bars and then on the other side.

US Patent 5,154,333 describes a process of forming semiconductor lasers. The lasers are formed adjacent to each other on a semiconductor wafer. The semiconductor wafer is cut into bars.

The applicant has observed that one of the critical points of the whole semiconductor bar production process is found at stage d). This is because, at this stage of processing, the bars cut in stage c) are manipulated in order to be placed in a position such that the machine for carrying out the subsequent processing (stage e) can operate in the correct way.

More particularly, the semiconductor bars have to be stacked on top of each other in a predetermined position. The tolerance on the positioning of the bars is very small, since the characteristics of the coatings, which will be determined in stage e), must be as similar as possible in all the bars.

Moreover, the manipulation of the bars takes place in an environment which is not of the high-vacuum type, unlike the other stages of processing in the machines which take place in a high vacuum. This can cause damage to the bars or degradation of the characteristics of the devices which are formed on the semiconductor bars. For example, for a semiconductor laser device formed on these bars, such degradation of the characteristics can adversely affect the correct operation of the device.

The applicant has found that it is possible to stack the bars together in such a way that the surfaces of the bars are essentially all on the same plane, by moving all the bars simultaneously, in other words without carrying out any manipulation on each bar separately.

The applicant has produced a device for moving semiconductor bars which enables the said bars to be stacked on top of each other with high precision. This device makes it possible to pick up the bars directly from the support of the machine which cuts the substrate into bars, without any need to pick up each bar individually and/or manually. The device comprises a transport tray for picking up the bars, the bar positioning seats in this tray being complementary to the bar positioning support seats in the machine which cuts the substrate. The bars are then positioned on this transport tray, already stacked on top of each other, in the correct position for the subsequent processing. After this, the bars deposited in an inverted position on a tray, which is preferably inserted directly into the machine which carries out this subsequent processing; in particular, if the bars are semiconductor bars on which lasers are formed, this subsequent processing is the formation of mirrors with specified and controlled reflectivity.

The whole stage of manipulating the bars takes place without any individual movement of any bar. Thus the sensitive parts of the bars are protected from any damage or from contacts which could cause degradation of the characteristics of the devices formed on them.

The movement of the bars is considerably accelerated by comparison with the case where each bar is moved manually. In particular, the time taken to transfer one batch of bars, regardless of the total number, is approximately 1 minute, whereas the time taken to move a single bar by the conventional method is approximately 40 s.

Moreover, the task of the operator who transfers the bars from one machine to the next is greatly facilitated.

For the purposes of the present description, a production process for semiconductor lasers is described by way of example; the present invention is applicable in a similar way to production processes for semiconductor optical devices, in which the bars have to be extracted from one machine which carries out one stage of the process, in which the devices are separated from each other, and inserted into a further machine which carries out a subsequent stage of processing of the said optical devices in which the processing is carried out on all the devices simultaneously.

The applicant has observed that, in the said stage of forming a coating on the bars (stage e), the positioning of the bars is considered to be correct if:
- the bars are positioned in such a way that their two opposite sides are exposed to the plasma, one at a time;
- during the exposure of one side, the other side, whether previously subjected to the PECVD process or not yet subject to it, does not suffer any damage;
- the sides adjacent to the sides to be subjected to the PECVD process are totally covered, in such a way that any deposition of layers of material on to them is prevented;
- the sides adjacent to the sides to be subjected to the PECVD process do not suffer any damage;
- the system of housing the bars does not adversely affect the characteristics of uniformity required from the optical coatings deposited on the bars.

The applicant has produced a process support for the said coating stage which meets the above requirements, in which the bars are inserted into the said support and held in the same position throughout the coating process. This makes it possible to expose all the surfaces of the bars on which the coating is formed without any need to change the position of the bars in the support. At the same time, the parts of the bars which are already coated are protected while the coating is formed on the other surfaces. The support comprises a base and a supporting structure for the bars. The base and the supporting structure can be detached from each other.

If the processing carried out on one surface of the bar does not affect subsequent processing to be carried out on the opposite surface, or does not affect processing previously carried out on the opposite surface, the base can be removed. Thus the supporting structure holds the (adjacent) bars by the end of each bar, leaving both sides free, and these sides can then be processed separately simply by moving the supporting structure together with all the bars.

A first aspect of the present invention relates to a method for moving a plurality of semiconductor bars in the stages of positioning them on and removing them from equipment for producing semiconductor devices, characterized in that it comprises the following stages:
- simultaneously picking up the said semiconductor bars contained in a process support of a first machine which carries out a first processing operation on the said bars;
- simultaneously positioning the said bars adjacent to each other;
- inserting the said bars, adjacent to each other, into a support for a second stage of processing.

Preferably, the said stage of inserting the said bars comprises placing the bars in a storage tray.

Preferably, the said stage of inserting the said bars comprises placing the bars in a moving process support.

A further aspect of the present invention relates to a device for moving a plurality of semiconductor bars from a first machine, comprising a first process support for the said bars, to a second machine, comprising a second process support for the said bars, characterized in that it comprises a transport tray capable of transferring the said plurality of bars simultaneously from the said first support to the said second support.

Preferably, the said transport tray is capable of transferring the said plurality of bars simultaneously into an intermediate storage tray for the said bars.

In particular, the said transport tray comprises a plurality of seats arranged to form a mirror image of the positions of the said bars in the said first process support.

Preferably, the said transport tray comprises a U-shaped structure whose opposing sides comprise the said plurality of seats.

Preferably, the said transport tray comprises a pair of pins placed in a position such that they fit into holes present in the said first support.

In particular, the said seats of the said transport tray have a rectangular internal cross section.

In particular, the said seats are arranged to form a mirror image of the positions of seats present on the said storage tray.

Preferably, the said seats of the said transport tray have a trapezoidal internal cross section.

Preferably, the said plurality of seats is arranged to form a mirror image of the positions of seats in the said second support.

A further aspect of the present invention relates to a process support of a machine for processing semiconductor bars, comprising a base with which is associated a supporting structure on which the said bars can be placed adjacent to each other, characterized in that the said base is detachable from the said supporting structure.

Preferably, the said supporting structure comprises a plurality of slide-in modules, into which the said bars are inserted, these modules being secured laterally by a pair of guide rails.

In particular, the said supporting structure comprises a rear stop device and a front stop device for the said slide-in modules..

Preferably, the said supporting structure comprises a locking system for the said slide-in modules, comprising an extender element, a pair of extension springs, a spacer element and a locking pin.

A further aspect of the present invention relates to a supporting structure for semiconductor bars in a machine for processing the said bars, characterized in that it comprises a plurality of slide-in modules which form the said seats, the said modules being movable between an open position in which the bars are inserted into the said seats and a closed position in which the bars are locked in the said seats.

Further characteristics and advantages of the present invention can be discovered in greater detail from the following description, with reference to the attached drawings, provided solely for the purposes of explanation and without any restrictive intent, which show:
in Figure 1, a semiconductor laser;
in Figure 2a, an exploded view of a bar support and a transport tray according to the present invention;
in Figure 2b, the bar support and the transport tray joined together according to the present invention;
in Figure 2c, the bar support and the transport tray joined together in an inverted position with respect to Figure 2b, according to the present invention;
in Figure 2d, an enlarged detail of Figure 2b, showing the area of coupling between the bar support and the transport tray;
in Figure 2e, an enlarged detail of an embodiment of the transport tray, showing the area which has seats for receiving the bars according to the present invention;
in Figure 2f, an enlarged detail of a further embodiment of the transport tray, showing the area which has seats for receiving the bars according to the present invention;
in Figure 3a, the transport tray of Figures 2 and a storage tray according to the present invention;
in Figure 3b, the transport tray and the storage container of Figure 3a, coupled according to the present invention;
in Figure 3c, an enlarged detail of Figure 3b, showing the area of coupling between the transport tray and the storage tray;
in Figure 3d, a detail of the guides for receiving the storage tray of Figure 3a;
in Figure 4a, a moving process support according to the present invention;
in Figure 4b, an exploded view of the moving process support of Figure 4a according to the present invention;
in Figure 4c, the moving process support of Figure 4b assembled according to the present invention;
in Figure 4d, a slide-in module of the moving support of Figure 4b according to the present invention;
in Figure 4e, a plurality of modules of figure 4d coupled together and viewed from above;
in Figure 5a, a transport tray of Figures 2 and a moving process support according to the present invention;
in Figure 5b, the transport tray and the moving process support of Figure 4a joined according to the present invention.

The figures listed above and the following description of them represent an embodiment of the present invention which relates to the movement of semiconductor bars in a process of fabrication of semiconductor lasers. The present invention is equally applicable to a process of fabrication of optical devices formed on semiconductor bars, in which the movement of these bars has essentially the same characteristics as those described above.

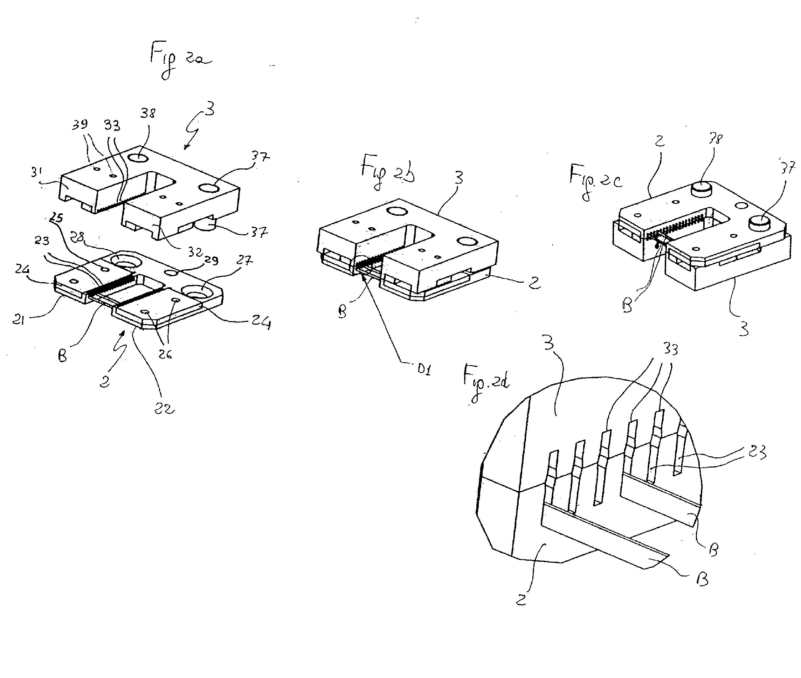

Figure 2a shows a process bar support 2 and a transport tray 3 according to one aspect of the present invention. This process bar support and this transport tray are preferably made from a metallic material, for example AISI-316L steel, or metal alloys. Alternatively, this process bar support and this transport tray can be made from a plastic material. In general, these components can be made from a material which does not affect the processing carried out on the bars and which, during this processing, does not modify its characteristics in such a way as to change the positions of the bars.

For the purposes of the present invention, the term "process bar support" denotes a component capable of supporting the semiconductor bars adjacent to each other.

For the purposes of the present invention, the term "transport tray" denotes a component capable of picking up simultaneously all the bars contained in the said process bar support and of placing them in a suitable position for a subsequent stage of processing the bars.

The process bar support 2 is a component of the machine which cuts the substrate into bars and passivates the facets (stage c). The said support comprises an essentially U-shaped structure. Each of the sides 21 and 22 of the inner edge of this structure comprises a plurality of seats 23 opposite the seats of the other side. The bars B are placed transversely in these seats, after the operation of cutting and passivation of the facets has been carried out on them. The support also comprises, on each of the said sides 21 and 22, a plate 24 which can lock the bars in their seats 23. This plate is fixed to the U-shaped structure, by means of a pair of screws or equivalent means which are inserted into through holes 25 and 26, located centrally on each bar, which match corresponding holes present in the U-shaped structure (not shown). Two additional holes 27 and 28, whose function is described below, are shown in the rear part of the support.

The support also comprises an element (not shown) for coupling to the machine which cuts the bars; this element is fixed to the support by means of a hole 29, formed in the central area of the said rear part of the U-shaped structure.

The transport tray 3 preferably comprises a U-shaped structure whose dimensions are advantageously similar to those of the U-shaped structure of the bar support 2. Each of the sides 31 and 32 of the internal edge of this structure has a plurality of seats 33, opposite those of the other side, and preferably similar in shape and dimensions to the seats 23 of the bar support 2.

The transport tray also comprises, in its rear part, a pair of pins 37 and 38 placed in positions such that they fit the holes 27 and 28 present in the bar support 2. These pins are advantageously interchangeable with pins of different sizes, for coupling to further supports whose holes can have sizes different from those of the holes 27 and 28. On the upper part, in a central position, are additional through holes 39 whose function is described below.

Figure 2b shows the bar support 2 and the transport tray 3 joined together, and Figure 2d shows a detail of the coupling area, in which the way in which the seats 23 of the bar support match the seats 33 of the transport tray is shown in detail. The seats 33 of the transport tray preferably have a rectangular internal cross section, as shown in Figure 2e, or alternatively a trapezoidal internal cross section, in other words having one of the two sides inclined, as shown in Figure 2f.

The bars B are placed transversely in the seats 23 of the bar support 2 after the operation of cutting and passivation of the facets. The subsequent processing forms a coating, on the surfaces of the facets, which produces the characteristics of reflectivity suitable for the correct operation of each device in the bar (stage e). The bars are all picked up simultaneously by the bar support 2, and are then preferably placed on a moving support which is inserted into the machine which carries out the said stage e), or alternatively on a storage tray to wait for subsequent processing.

The simultaneous extraction of all the bars from the bar support 2 is carried out by means of the described transport tray 3.

The operation is carried out as described below.

The transport tray 3 is positioned above the bar support 2, as shown in Figure 2b, the pins 37 and 38 of the transport tray 3 are inserted into the holes 27 and 28 of the bar support, providing a precise joining of the two parts. The transport tray and the bar support, joined together, are inverted, bringing the transport tray into the base position and the bar support into the cover position, as shown in Figure 2c.

Thus the bars, which are prevented from moving horizontally by the plates 23 and 24, all slide into the seats 33 of the transport tray.

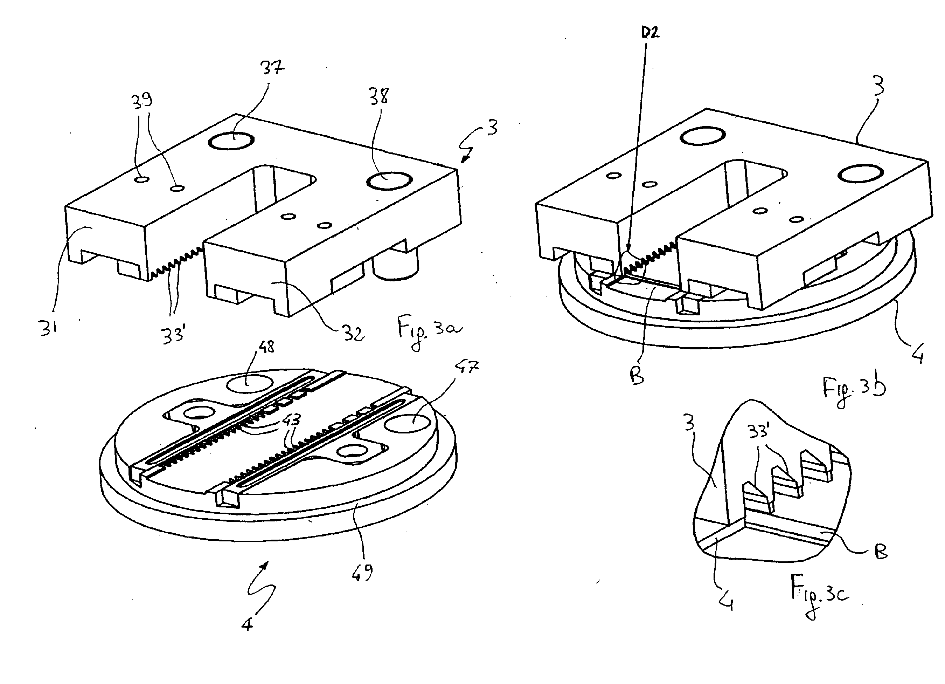

Figure 3a shows an example of a storage tray 4 according to one aspect of the present invention. This storage tray is preferably made from a metallic material, for example AISI-316L steel, or metal alloys.

For the purposes of the present invention, the term "storage tray" denotes a component capable of holding the bars in such a position that they can be visually inspected, while the bars are awaiting transfer to a subsequent stage of processing. In particular, the said transport tray deposits the bars in the said storage tray.

This example of a storage tray comprises a pair of opposing guides 43, preferably with suitable shapes and dimensions for joining to the guides 33 of the transport tray 3, a pair of through holes 47 and 48 located in positions such that they can be connected to the pins 37 and 38 of the transport tray 3. The storage tray 4 is, for example, circular in shape, but can equally well have another shape, rectangular for example. Additionally, this storage tray comprises a circumferential edge 49 which can mate with a protective cover (not shown) which covers the tray while the bars are in their seats.

The transfer of the bars B from the transport tray 3 to the storage tray 4 preferably takes place in the following way. In the transport tray 3 suitable for this transfer, the aforesaid seats are those of trapezoidal shape, with one inclined side (Figure 2f). The storage tray 4 is positioned above the transport tray which has the laser bars B in the seats 33 within it. The pins 37 and 38 of the transport tray are inserted into the holes 47 and 48 of the storage tray, providing a precise joint between the two components. The transport tray 3 and the storage tray 4, joined together in this way, are inverted to bring the storage tray into the base position and the transport tray into the cover position, as shown in Figure 3b.

The bars in the transport tray are housed in the seats 33 in an inclined position as shown in Figure 2f. The inversion of the transport tray and the storage tray, which are joined together, causes the bars B to fall into the seats 43. These bars, owing to their inclined position in the transport tray, are positioned in the seats 43 of the storage tray 4 at 90° to their initial position in the bar support 2. The inclined sides of the transport tray are preferably formed in such a way that the surfaces of the bars on which the superimposed layers of material were deposited in stage a) are facing upwards when the bars are in their final position in the storage tray. Thus visual inspections can be carried out on the bar, by means of a microscope for example, to check their condition.

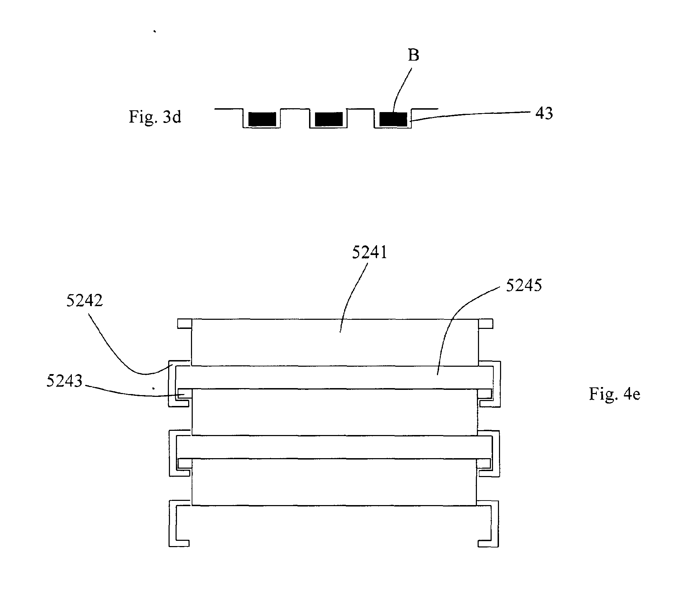

In particular, the sequence of movements of the bars in their transfer from the bar support to the storage tray is shown in Figures 2e, 2f and 3d.

In the seats 23 of the bar support 2, the bars are in a vertical position; in the transport tray 3 they lie in the seats 33 in an inclined position; and in the storage tray 4 they lie in the seats 43 in a horizontal position. In all cases, the bars in the said transport tray are located in positions in which they are adjacent to each other.

When the operations on the bars in this storage tray have been completed, the bars can advantageously be reinserted into the said transport tray by carrying out the movements described above, in reverse order. In particular, the transport tray 3 is positioned above the storage tray 4 which has the laser bars B inside it. The pins 37 and 38 of the transport tray are inserted into the holes 47 and 48 of the storage tray, providing a precise joint between the two components. The transport tray 3 and the storage tray 4, joined together in this way, are inverted, bringing the transport tray into the base position and the storage tray into the cover position.

The inversion of the storage tray and the transport tray, joined together, causes the bars B to fall into the seats 33. During the inversion, these bars lie in an inclined position in the transport tray, and at the end of the operation they again lie in a vertical position.

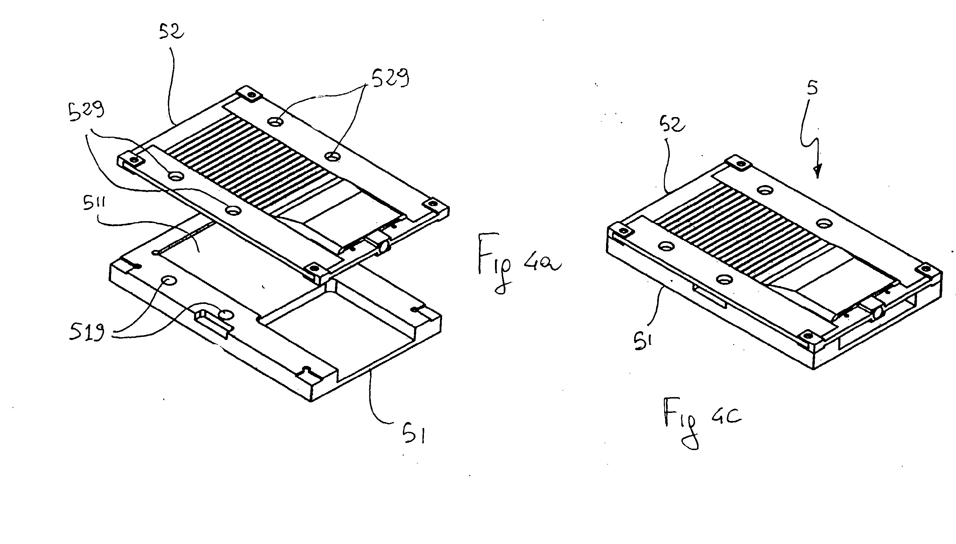

Figure 4a shows a moving process support 5 according to one aspect of the present invention. This moving process support is preferably made from a metallic material, for example AISI-316L steel, or metal alloys. In general, the said moving process support can be made from a material which does not affect the processing carried out on the bars and which, during this processing, does not modify its characteristics in such a way as to change the positions of the bars.

For the purposes of the present invention, the term "moving process support" denotes a component capable of supporting the bars adjacent to each other in such a way that they lie in a suitable position for a subsequent stage of processing.

This moving process support preferably comprises a base 51 and a supporting structure 52. The said supporting structure 52 can be fixed to the said base 51 by screws or equivalent means, such as push-in pins, which are inserted into through holes 529 located in positions corresponding to holes 519 formed in the said base 51. The positions of the holes 519 and 529 are preferably chosen according to the requirements of coupling between the base and the supporting structure.

Figure 4b shows the moving process support of Figure 4a in an exploded view; in particular, the said supporting structure 52 comprises a rear stop device 521, a front stop device 522, a pair of guide rails 523, a plurality of slide-in modules 524, an extender element 525, a pair of extension springs 526, a spacer element 527 and a locking pin 528.

An example of a slide-in module 524 is shown in Figure 4d in particular, and comprises a central body 5241, preferably of parallelepipedal shape, at whose ends are formed a pair of projecting pins 5243 and a pair of C-shaped coupling elements 5242. The slide-in modules are adjacent to each other and the coupling elements 5242 of one module are coupled to the pins 5243 of the next module. Thus, when all the modules are coupled together, as shown in Figure 4e, a plurality of seats 5245 capable of housing the laser bars is formed in the spaces between one module and the next. The widths of these seats can vary, because the inner parts of the coupling elements 5242 preferably have larger dimensions than the pins 5243, and the pins can slide for a limited distance in the coupling elements 5242.

The modules are kept coupled together laterally by the guide rails 523, and at the front and rear by the said front stop device 522 and rear stop device 521. The system formed by the springs 526, the extender element 525, the spacer element 527 and the locking pin 528 allows the seats 5245 to be in a first, "open", condition, in other words one of maximum width, in which the laser bars are inserted into them, and in a second, "closed", condition, in which the widths of the seats are reduced and the bars are locked in them. The springs 526 ensure the stable locking of the bars in the seats. The locking pin has two positions, a first position in which it is superimposed on the spacer element 527 and pushes the springs 526 against the extender element 525 to reduce the width of the seats 5245, thus locking the bars, and a second position in which the spacer element 527 keeps the pin in a retracted position with respect to the first position, in such a way that the springs 526 are released and the coupled modules are free to move apart from each other, thus widening the seats 5245.

The transfer of the bars B from the transport tray 3 to the moving process support 5 takes place in the following way. The transport tray 3 capable of providing this transfer is made in the embodiment which has seats of parallelepipedal shape, because, in the moving process support, the bars have to be inserted in such a position that their surfaces which were cut and passivated in the preceding stages of the process are positioned horizontally.

The moving process support 5 is placed above the transport tray which has the bars B within it in the seats 33'. In this embodiment of the invention, the pins 37 and 38 are removed because they are not used. To provide the joint between the two parts, use is made of pins (not shown in the figure) which are inserted into the through holes 39 of the transport tray 3 and into the holes 529 and 519 of the moving process support. The holes 529 and 519 advantageously have a double function, since they are used both to fix the base 51 to the supporting structure 52 of the moving support 5 and to join the transport tray 3 to the moving support.

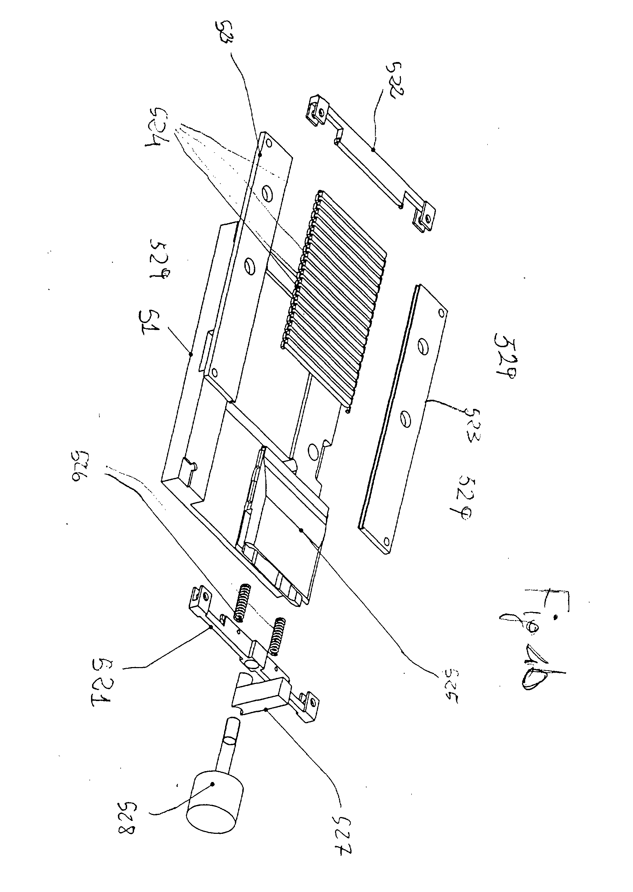

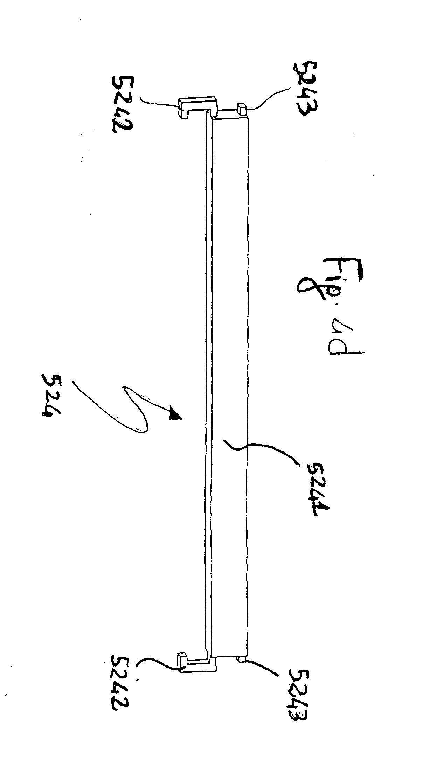

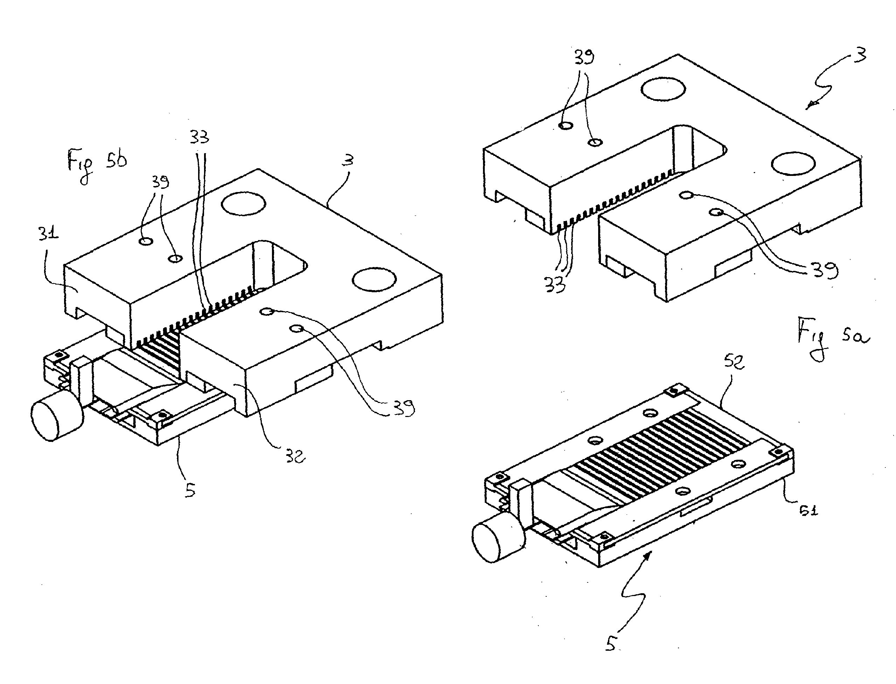

The transport tray 3 and the moving process support 5, joined together in this way, are inverted, bringing the moving process support into the base position and the transport tray into the cover position, as shown in Figure 5b.

The bars in the transport tray are housed in the seats 33 in the vertical position, as shown in Figure 2f. The inversion of the transport tray and of the moving process support, joined together, causes the bars B to fall into the seats 5245 of the moving process support. These bars are positioned in the seats of the moving process support in a vertical position, with one of the two sides on which the passivation of the mirrors was carried out resting in contact with the base 51 of the support. This base has (Figure 4a) a recess 511, preferably rectangular, corresponding to the location of the coupling modules of the supporting structure. The width of the said recess is chosen in such a way that only the end portions of the bars rest on the said base. None of the remaining part of the side which rests on the base, and on which the passivation was carried out, comes into contact with the base 51. Thus any damage which might occur when the bars fall from the transport tray into the moving process support 5, and the contact of these bars with the base 51, are considerably limited.

The subsequent processing to be carried out on the bars consists in the formation of a coating on the facets in such a way as to determine the characteristics of reflectivity suitable for the correct operation of each laser (stage e). This type of processing is carried out, for example, by a PECVD (plasma-enhanced chemical vapour deposition) process. This operation is carried out on the sides of the bars on which the facets are located. Since the mirrors are formed on opposite sides of the rectangular bar, the deposition takes place initially on one side of all the bars and then on the other side. For this purpose, the moving process support is inserted into the machine without its base 51. Thus both sides of the bars to be exposed to the chemical process are free of restrictions. The deposition can be carried out on both sides of the bars without any need to move the bars from their fixed position within the coupling modules. The deposition is carried out initially on one side of the bars, after which the moving process support is rotated through 180° and the deposition is carried out on the opposite side of the bars.

According to the present description, the device for moving semiconductor laser bars in the stages of placing them on and removing them from equipment carries out the movement of a plurality of semiconductor bars from a first machine, comprising a first process support, namely the aforesaid bar support 2, to a second machine comprising a second process support.

The transport tray 3 is capable of transferring the said plurality of bars simultaneously from the said bar support 2 to the said second support.

In one embodiment, the second support is formed by the process support 5, which is inserted directly into the machine which carries out stage e) of the process described above. Thus a process in which stages c), d) and e) are carried out in sequence is provided.

In a further embodiment, the said second support is formed by the intermediate storage tray 4 in which the bars are placed in order to carry out their visual inspection as described above. Thus a process in which there is a pause in the processing operations between stage d) and stage e) is provided.

Additionally, the process support 5 positions the bars in such a way that the two surfaces on which the coating is formed are both available, without the need to remove the bars from the component between the processing of the first surfaces and the processing of the second surfaces of the bars.

## Claims

1. Method for moving a plurality of semiconductor bars in the stages of positioning them on and removing them from equipment for producing semiconductor devices, **characterized in that** it comprises the following stages:
• simultaneously picking up the said semiconductor bars contained in a process support of a first machine which carries out a first processing operation on the said bars;
• simultaneously positioning the said bars adjacent to each other;
• inserting the said adjacent bars into a support for a second stage of processing.

2. Method according to Claim 1, in which the said stage of inserting the said bars comprises placing the bars in a storage tray.

3. Method according to Claim 1, in which the said stage of inserting the said bars comprises placing the bars in a moving process support.

4. Device for moving a plurality of semiconductor bars from a first machine, comprising a first process support for the said bars, to a second machine, comprising a second process support for the said bars, **characterized in that** it comprises a transport tray (3) capable of transferring the said plurality of bars simultaneously from the said first support to the said second support.

5. Device according to Claim 4, in which the said transport tray is capable of transferring the said plurality of bars simultaneously into an intermediate storage tray (4) for the said bars.

6. Device according to Claim 4, in which the said transport tray comprises a plurality of seats (33) arranged to form a mirror image of the positions of the said bars in the said first process support (2).

7. Device according to Claim 4, in which the said transport tray comprises a U-shaped structure whose opposing sides (31, 32) comprise the said plurality of seats (33).

8. Device according to Claim 4, in which the said transport tray comprises a pair of pins (37, 38) placed in a position such that they fit into holes (27, 28) present in the said first support (2).

9. Device according to Claim 4, in which the said seats (33) of the said transport tray (3) have a rectangular internal cross section.

10. Device according to Claim 5, in which the said seats (33) are arranged to form a mirror image of the positions of seats (43) present on the said storage tray (4).

11. Device according to Claim 10, in which the said seats (33) of the said transport tray (3) have a trapezoidal internal cross section.

12. Device according to Claim 4, in which the said plurality of seats (33) is arranged to form a mirror image of the positions of seats (53) in the said second support.

13. Process support (5) of a machine for processing semiconductor bars, comprising a base (51) with which is associated a supporting structure (52) on which the said bars can be placed adjacent to each other, **characterized in that** the said base is detachable from the said supporting structure.

14. Process support according to Claim 13, in which the said supporting structure comprises a plurality of slide-in modules (524), into which the said bars are inserted, these modules being secured laterally by a pair of guide rails (523).

15. Process support according to Claim 14, in which the said supporting structure comprises a rear stop device (521) and a front stop device (522) for the said slide-in modules.

16. Process support according to Claim 15, in which the said supporting structure comprises a locking system for the said slide-in modules, comprising an extender element (525), a pair of extension springs (526), a spacer element (527) and a locking pin (528).

17. Supporting structure for semiconductor bars in a machine for processing the said bars, **characterized in that** it comprises a plurality of slide-in modules (524) which form the said seats, the said modules being movable between an open position in which the bars are inserted into the said seats and a closed position in which the bars are locked in the said seats.
